# EUROPEAN PATENT APPLICATION

(11) **EP 4 243 257 A1**
(43) Date of publication of application: **13.09.2023**
(21) Application number: 23155316.5
(22) Date of filing: 07.02.2023
(51) Int. Cl.: H02K 15/095

(54) **WINDING DEVICE**

(30) Priority: 11.03.2022 JP 2022038053
(71) Applicant: Mitsuba Corporation, Kiryu-shi, Gunma 376-8555 (JP)
(72) Inventor: OHKAWARA, Tomoki, Kiryu-shi, Gunma, 3768555 (JP); ISHIDA, Takahito, Kiryu-shi, Gunma, 3768555 (JP); FUKUSHIMA, Yusuke, Kiryu-shi, Gunma, 3768555 (JP); SUGIYAMA, Masayuki, Kiryu-shi, Gunma, 3768555 (JP)
(74) Representative: Kurig, Thomas

(57) **Abstract**

Even when a winding wire is wound around a winding object after the cross-sectional shape thereof is deformed half way, deterioration in product quality caused by damages in a winding wire is suppressed. The disclosure provides a winding device (20) supplying a winding wire from a winding reel (21) to a split core (7) side and winding it around a teeth portion of the split core (7), including: a rectangular wire forming machine (22) arranged on a downstream side of the winding reel (21) and changes a cross-sectional shape of a round wire having a substantially circular cross-section sent out from the winding reel (21) side to form a rectangular wire having a substantially rectangular cross-section; and a damage detection portion (24) arranged on a downstream side of the rectangular wire forming machine (22) and detecting a damage in the rectangular wire.

## Description

### BACKGROUND

### Technical Field

This disclosure relates to a winding device.

### Related Art

In general, a brushless motor or the like configured with a rotor having a magnet and a stator having a winding wire wound therearound can have its performance improved as the density (space factor) of the winding wire wound around the teeth of the stator increases. Here, in order to increase the space factor, there are cases where a winding wire composed of a so-called rectangular wire having a substantially rectangular cross-section is used. Due to its shape characteristics, the rectangular wire can reduce the gap between the winding wires in the stator compared to a round wire, such that the space factor can be further improved.

For example, Patent Literature 1 discloses a technique of forming a rectangular wire from a round wire by a rectangular wire forming device and winding the formed rectangular wire around the teeth portion of a split core. In this rectangular wire forming device, the round wire having a circular cross-section from a winding reel is crushed from up and down by a first roller, and then crushed from the side by a second roller to form a temporary rectangular wire having a substantially square cross-section, finally, and finally crushed again from up and down by a third roller to form a rectangular wire.

### Citation List

### Patent Literature

[Patent Literature 1] JP 2014-166102

### SUMMARY

### Technical problem

As in the technique described in Patent Literature 1, in the case where a winding wire is made to change its cross-sectional shape and then supplied to the teeth portion of a split core, there is a possibility that damages may occur in the winding wire when the cross-sectional shape of the winding wire is changed. For this reason, when forming a coil by winding the winding wire on the teeth portion of the split core in multiple layers after changing the cross-sectional shape of the winding wire, there is a possibility that one coil may include many locations where the damage of the winding wire occurs, and the product quality may be deteriorated.

Therefore, the purpose of this disclosure is to provide a winding device capable of suppressing a deterioration in product quality caused by damages on a winding wire even when the winding wire is wound around a winding object after the cross-sectional shape thereof is deformed half way.

### Solution to Problem

In order to solve the above problems, a first aspect of the disclosure is a winding device supplying a winding wire from a wire supply source to a side of a winding object and winding it around the winding object. The winding device includes: a winding wire deformation portion arranged on a downstream side of the wire supply source and changing a cross-sectional shape of the winding wire; and a damage detection portion arranged on a downstream side of the winding wire deformation portion and detecting a damage in the winding wire.

A second aspect of the disclosure is the winding device according to the first aspect, further including: a control unit executing a predetermined process based on detection of a damage by the damage detection portion.

A third aspect of the disclosure is the winding device according to the second aspect, in which the control unit executes the predetermined process when a number of damages included in a winding wire per unit amount wound around the one winding object is equal to or more than a predetermined threshold.

A fourth aspect of the disclosure is the winding device according to the third aspect, including: a pull-out amount detection portion detecting a pull-out amount of the winding wire pulled out from the wire supply source. The control unit detects the number of damages included in the winding wire per unit amount based on a current pull-out amount detected by the pull-out amount detection portion and a pull-out amount when the damage detection portion detects the damage.

A fifth aspect of the disclosure is the winding device according to the second aspect, in which the control unit executes the predetermined process when the damage detection portion detects the damage in the winding wire.

A sixth aspect of the disclosure is the winding device according to any one of the second aspect to the fifth aspect, including: a notification portion controlled by the control unit and notifying information about the damage in the winding wire. The predetermined process executed by the control unit includes notification by the notification portion.

### Effects

According to this disclosure, deterioration in product quality due to damages on the winding wire can be suppressed even when the winding wire is wound around a winding object after the cross-sectional shape thereof is deformed half way.

### BRIEF DESCRIPTION OF THE DRAWINGS

Figure 1 is a perspective view of a motor having split cores.
Figure 2 is a side view of a split core and a coil.
Figure 3 is a cross-sectional view taken along line III-III in Figure 2.
Figure 4 is a schematic view of a winding device according to an embodiment of the disclosure.
Figure 5 is a perspective view of a rectangular wire forming machine.
Figure 6 is an explanatory view showing a process of forming a rectangular wire.
Figure 7 is an explanatory view for detecting damages included in a winding wire per unit amount.

### DESCRIPTION OF THE EMBODIMENTS

An embodiment of the disclosure will be described below with reference to the drawings. In each figure, W indicates a width direction of a rectangular wire, T indicates a thickness direction of the rectangular wire, A indicates an axial direction of a coil, and R indicates the radial direction of the coil.

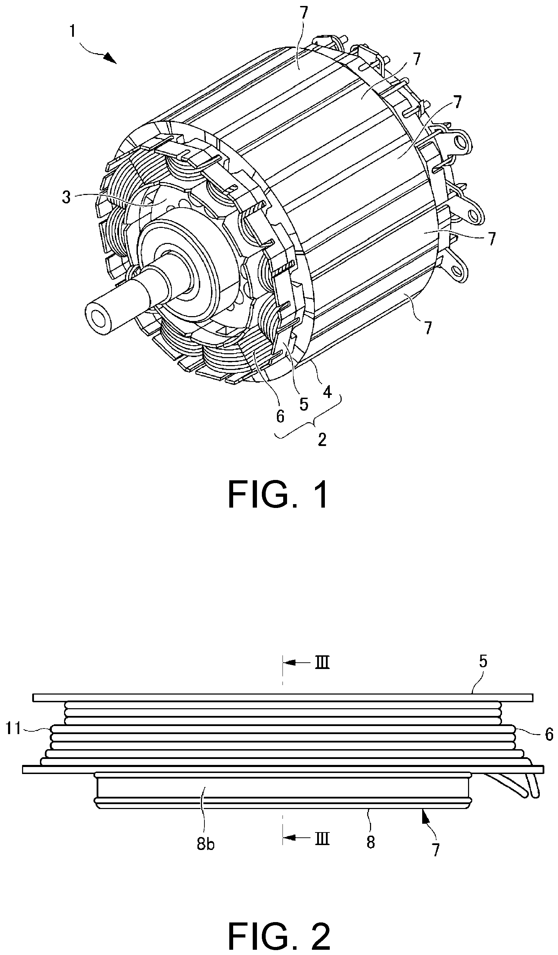

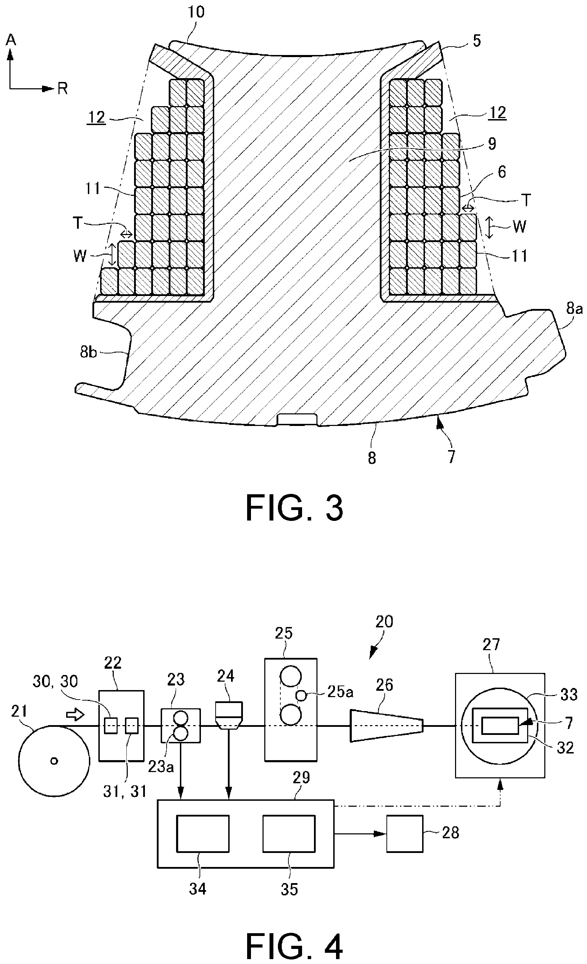

Figure 1 is a perspective view of a motor having split cores. Figure 2 is a side view of a split core and a coil. Figure 3 is a cross-sectional view taken along line III-III in Figure 2.

As shown in Figure 1, the winding device according to this disclosure is to be applied to, for example, a winding device for making a stator 2 of a brushless motor 1 (rotating electric machine). The brushless motor 1 (hereinafter referred to as "motor 1") includes the stator 2 press-fitted into a housing (not shown), and a rotor 3 arranged on the inner side of the stator 2 in a motor radial direction and rotatable with respect to the stator 2.

The stator 2 includes a stator core 4, an insulating insulator 5 mounted on the stator core 4, and a coil 6. The stator core 4 of this embodiment is one split-core type stator core 4 that is split in a motor circumferential direction, and is formed by annularly connecting a plurality of split cores 7 in the motor circumferential direction.

As shown in Figures 2 and 3, the split core (winding object) 7 of the stator core 4 includes: a yoke portion 8 having a substantially arcuate cross-section extending in the motor circumferential direction on the outer side in the motor radial direction, a teeth portion 9 extending inward in the motor radial direction from the yoke portion 8, a flange portion 10 extending from an inner end portion of the teeth portion 9 in the motor radial direction to both sides in the motor circumferential direction is provided. In this embodiment, the split core 7 is formed by laminating a plurality of metal plates in a motor axial direction, for example, and extends linearly along the motor axial direction. In a state where the stator core 4 is formed by annularly connecting the plurality of split cores 7 in the motor circumferential direction, the yoke portion 8 constitutes a substantially cylindrical back yoke that forms an annular magnetic path. The coil 6 of this embodiment is formed by winding a rectangular wire (winding wire) 11 around the teeth portion 9. Moreover, the split core 7 may have a skew angle that is inclined with respect to a length direction of the split core 7 (motor axial direction). Further, in this embodiment, the teeth portion 9 of the split core 7 of the stator core 4 is exemplified as a winding object, but the winding object is arbitrary and may be applied to an armature core or the like. Moreover, the disclosure is also applicable to the case of winding a coil around a non-magnetic material, and the function and application of the coil are arbitrary.

Connection portions 8a and 8b for connecting the adjacent split cores 7 are formed at both end portions of the yoke portion 8 in the motor circumferential direction. One connection portion 8a extends in the motor axial direction while protruding outward in the motor circumferential direction. The other connection portion 8b is formed in the shape of a groove extending in the motor axial direction while being recessed inward in the motor circumferential direction, and is engageable with the one connection portion 8a. By engaging the connection portions 8a, 8b at both end portions of the yoke portion 8 in the motor circumferential direction with the connection portions 8b, 8a of the yoke portion 8 of the other split core 7 adjacent to both sides in the motor circumferential direction, the stator core 4 may be formed by connecting the plurality of split cores 7. The teeth portion 9 extends in the motor axial direction while protruding inward in the motor radial direction (rotation center side of the motor 1) from an intermediate portion (in this embodiment, substantially center) in the motor circumferential direction of an inner circumferential surface of the yoke portion 8. The flange portion 10 extends in the motor axial direction while protruding from the inner end portion of the teeth portion 9 in the motor radial direction to both sides in the motor circumferential direction.

On both sides in the motor circumferential direction of the teeth portion 9, a pair of slots 12 for winding a winding wire (a rectangular wire 11) forming the coil 6 are partitioned by the yoke portion 8, the teeth portion 9, and the flange portion 10. That is, the slot 12 is located inside a virtual line connecting an end portion of the yoke portion 8 in the motor circumferential direction and an end portion of the flange portion 10 in the motor circumferential direction (chain double-dashed line in Figure 3).

The insulator 5 is mounted on the split core 7 so as to cover the periphery of the teeth portion 9. The insulator 5 covers the portion of the split core 7 facing the slot 12 and also covers the end portions of the teeth portion 9 on both sides in the motor axial direction.

Figure 4 is a schematic view of a winding device 20 according to an embodiment of the disclosure.

As shown in Figure 4, a winding device 20 according to this embodiment includes: a winding reel (wire supply source) 21, a rectangular wire forming machine (winding wire deformation portion) 22, a pull-out amount detection portion 23, a damage detection portion 24, a tension device 25, a nozzle 26, a winding machine 27, a notification portion 28, and a controller (control unit) 29. The winding device 20 supplies the winding wire from the winding reel 21 to the side of the split core 7 (in this embodiment, the split core 7 supported by the winding machine 27) which is a winding object, and winds it on the teeth portion 9 of the split core 7 (see Figure 3). Each device is provided in the order of the winding reel 21, the rectangular wire forming machine 22, the tension device 25, the nozzle 26, and the winding machine 27 from an upstream side in a moving direction of the winding wire.

The winding reel 21 is a supply source (wire supply source) of a wire as a winding wire, and is pre-wound with a round wire (winding wire) 13 as a winding wire. A surface of a conductor of the round wire 13 is covered with an insulating film. Moreover, the wire supply source is not limited to the winding reel 21 as long as it is a supply source of the wire as the winding wire.

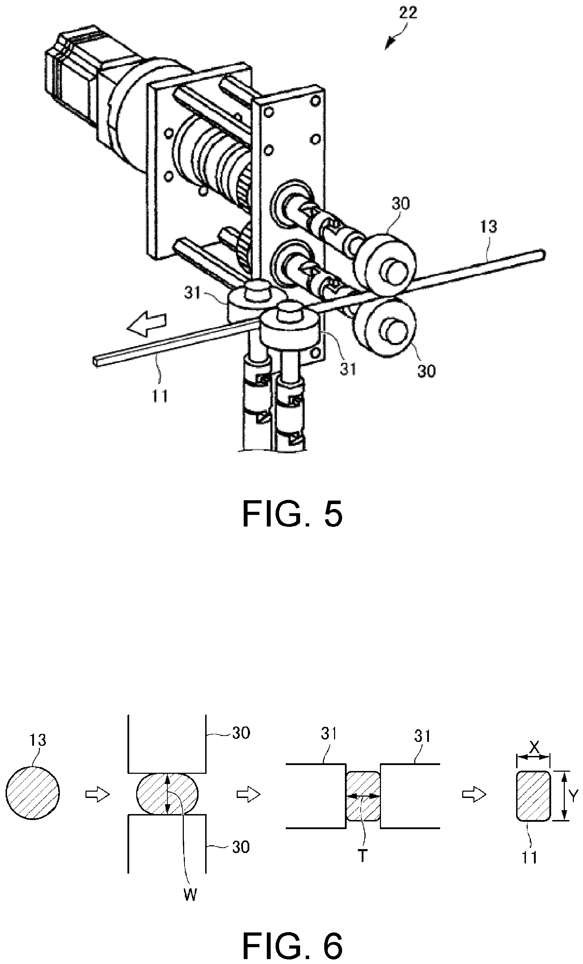

Figure 5 is a perspective view of the rectangular wire forming machine 22. Figure 6 is an explanatory view showing a process of forming the rectangular wire 11. Moreover, Figure 6 shows a state in which the round wire 13 and the rectangular wire 11 as the winding wire are viewed from a distribution direction.

As shown in Figures 4 to 6, the rectangular wire forming machine 22 is arranged on the downstream side of the winding reel 21 and the upstream side of the nozzle 26 (i.e. upstream side of the winding machine 27), and changes the cross-sectional shape of the winding wire. The rectangular wire forming machine 22 of this embodiment deforms the cross-section shape of the round wire 13 having a substantially circular cross-section sent out from a winding reel 21 side (sent out in the white arrow direction shown in Figure 4 and Figure 5) to form the rectangular wire 11 having a substantially rectangular cross-section.

The rectangular wire forming machine 22 of this embodiment includes a pair of first rollers 30, 30 on the upstream side and a pair of second rollers 31, 31 on the downstream side. The first rollers 30, 30 apply compressive force from a width direction W (up-down direction in Figure 5) to the round wire 13 sent out from the winding reel 21 in the direction of the white arrow. The second rollers 31, 31 are arranged on the downstream side of the first rollers 30, 30, and apply compressive force from a thickness direction T (lateral direction in Figure 5) to the winding wire passing through the first rollers 30, 30. Moreover, the width direction W indicates a direction (direction in which rectangular wires 11 of the same layer are adjacent) along an axial direction A (axial direction of the coil 6) of the teeth portion 9 when the rectangular wire 11 is wound around the teeth portion 9 of the split core 7 (see Figure 3). Moreover, the thickness direction T is a direction intersecting the width direction W, and indicates a direction (laminating direction of the rectangular wire 11) along a radial direction R of the teeth portion 9 (radial direction of the coil 6) when the rectangular wire 11 is wound around the teeth portion 9 of the split core 7.

As shown in Figure 6, the rectangular wire forming machine 22 forms the rectangular wire 11 having a substantially rectangular cross-section in which a length X in the thickness direction T is shorter than a length Y in the width direction W. The round wire 13 from the winding reel 21 is first compressed from both sides in the width direction W by the first rollers 30, 30, and then compressed from both sides in the thickness direction T by the second rollers 31, 31. A spacing between the first rollers 30, 30 and a spacing between the second rollers 31, 31 are variably controlled by a drive mechanism (not shown). A cross-sectional shape of the rectangular wire 11 is defined by the spacing between the first rollers 30, 30 and the spacing between the second rollers 31, 31. In a case where the spacing between the first rollers 30, 30 and the spacing between the second rollers 31, 31 are equal to or larger than a diameter of the round wire 13, the round wire 13 maintains its cross-sectional shape (circular cross-sectional shape) without being deformed by the rectangular wire forming machine 22. In this case, the round wire 13 is supplied to the winding machine 27 via the rectangular wire forming machine 22, the damage detection portion 24, the tension device 25, and the nozzle 26. The order in which the round wire 13 is compressed in the width direction W and the thickness direction T is not limited. Moreover, in addition to the first rollers 30, 30 and the second rollers 31, 31, other rollers may be added to compress the winding wires in the same direction (lateral direction or vertical direction) multiple times. Further, the winding wires may be subjected to one or more compressions only in one direction.

As shown in Figure 4, the pull-out amount detection portion 23 detects a pull-out amount L of the winding wire pulled out from the winding reel 21 (hereinafter simply referred to as "winding wire pull-out amount L"). The pull-out amount detection portion 23 of this embodiment is an encoder arranged on the downstream side of the rectangular wire forming machine 22. The pull-out amount detection portion 23 is connected to a controller 29. As a result, the controller 29 may acquire the winding wire pull-out amount L from the pull-out amount detection portion 23. The pull-out amount detection portion 23 of this embodiment detects the total amount (total length) of the winding wires pulled out after the operation of the winding device 20 is started as the winding wire pull-out amount L. Further, the pull-out amount detection portion 23 of this embodiment includes a roller 23a arranged in a winding wire supply path and rotates as the winding wire moves, and detects the winding wire pull-out amount L based on the amount of rotation (number of rotations) of the roller 23a. The configuration of the pull-out amount detection portion 23 is not limited to the above, and any configuration that may detect the pull-out amount of the winding wire may be used. For example, the winding wire pull-out amount L may be detected based on the number of rotations (rotational angle) of the winding reel 21 or the like. Moreover, in this embodiment, although the pull-out amount detection portion 23 is arranged on the downstream side of the rectangular wire forming machine 22, the arrangement position of the pull-out amount detection portion 23 is not limited thereto; it may be arranged at various positions where the winding wire pull-out amount L from the winding reel 21 may be detected.

The damage detection portion 24 is arranged on the downstream side of the rectangular wire forming machine 22 and the upstream side of the winding machine 27, and detects damages in the winding wire (the rectangular wire 11) whose cross-sectional shape has been deformed by the rectangular wire forming machine 22. The damage detection portion 24 of this embodiment is arranged on the downstream side of the pull-out amount detection portion 23 and the upstream side of the tension device 25. The damage detection portion 24 is connected to the controller 29. As a result, the controller 29 may acquire information about the presence or absence of damage in the winding wire from the damage detection portion 24. In this embodiment, the damage detection portion 24 detects damages penetrating an insulating film on a surface of a conductor of the winding wire. Examples of the damage detection portion 24 include, for example, a pinhole checker that applies voltage to a winding wire (the rectangular wire 11) that is moving from the rectangular wire forming machine 22 side to the winding machine 27 side to detect a damage (pinhole of insulating film) of the winding wire by monitoring an energization state (e.g. current leakage). The damages detected by the damage detection portion 24 are not limited to damages caused when the winding wire is deformed by the rectangular wire forming machine 22, but include damages originally present in the round wire 13 as an initial defect. The method of detecting a damage by the damage detection portion 24 is not limited to the method of applying a voltage to the winding wire and monitoring the energization state. For example, a method of discriminating damages from an external image of the winding wire by a CCD (Charge Coupled Device) camera or the like may be used. Moreover, in Figure 4, the damage detection portion 24 is arranged on the upstream side of the tension device 25, but the disclosure is not limited thereto, as long as it is arranged on the downstream side of the rectangular wire forming machine 22 and the upstream side of the winding machine 27.

The tension device 25 is arranged on the downstream side of the rectangular wire forming machine 22 (in this embodiment, downstream side of the damage detection portion 24) and the upstream side of the nozzle 26. The tension device 25 includes a tension pulley 25a and the like, and applies tensile force to the winding wire (the rectangular wire 11) between the rectangular wire forming machine 22 and the nozzle 26 to prevent loosening of the winding wire.

The nozzle 26 is arranged on the downstream side of the rectangular wire forming machine 22 (in this embodiment, the downstream side of the tension device 25) and the upstream side of the winding machine 27, and supplies the rectangular wire 11 formed by the rectangular wire forming machine 22 to the teeth portion 9 side of the split core 7 on the winding machine 27 side. The nozzle 26 supplies the rectangular wire 11 formed by the rectangular wire forming machine 22 to the teeth portion 9 side of the split core 7 supported by the winding machine 27 in such a way that the width direction W of the rectangular wire 11 is along the axial direction A of the teeth portion 9 and the thickness direction T of the rectangular wire 11 is along the radial direction R of the teeth portion 9 (see Figure 3).

The winding machine 27 is arranged on the downstream side of the nozzle 26. The winding machine 27 includes a core support portion 32 capable of supporting (setting) the split core 7, and a rotation mechanism 33 for rotating the core support portion 32 around a rotary shaft along the axial direction A of the teeth portion 9 of the split core 7. When the core support portion 32 is rotated by the rotation mechanism 33 while the split core 7 is set on the core support portion 32, the split core 7 rotates about the rotation axis along the axial direction A with respect to the nozzle 26. The rectangular wire 11 is pulled out from the nozzle 26 by rotating the split core 7 by the winding machine 27, and the rectangular wire 11 is wound around the teeth portion 9 of the split core 7. The winding machine 27 may include a guide member (not shown) that guides the rectangular wire 11 to a predetermined position on the teeth portion 9 of the split core 7. Moreover, in this embodiment, the split core 7 set on the core support portion 32 of the winding machine 27 is rotated with respect to the nozzle 26, but the disclosure is not limited thereto, for example, the nozzle 26 may be rotated with respect to the split core 7 set on the core support portion 32 of the winding machine 27.

The notification portion 28 is a device that is controlled by the controller 29 and is capable of notifying information about damages of the winding wire (hereinafter referred to as "winding wire damage information"). The winding wire damage information is information that is provided to the user to prevent deterioration in product quality due to damages of the winding wire, for example, information that there are damages in the winding wire, information that there are damages of a predetermined number or more in the winding wire, information that there are damages of a predetermined size or larger in the winding wire, and the like. Examples of the notification portion 28 include a lamp visible to the user, a speaker capable of generating sound or voice, and a display device capable of displaying text and images. The notification of the winding wire damage information by the notification portion 28 is performed, for example, by turning on a lamp, generating a buzzer sound or voice, displaying text or images on a display device, or the like. That is, the notification of the winding wire damage information by the notification portion 28 is not limited to providing detailed information about the damage, and may be notification for merely informing the user of the winding wire damage information. The number of notification portions 28 provided is not limited to one, and may be plural. Further, when a plurality of notification portions 28 are provided, the plurality of notification portions 28 may be of the same type, or the plurality of notification portions 28 may be of different types.

The controller 29 executes a predetermined process based on the detection of damages by the damage detection portion 24. The controller 29 includes a CPU (Central Processing Unit) and a storage portion (not shown), and functions as a determinator 34 and a device controller 35 by executing information processing in cooperation with software such as programs stored in the storage portion. The pull-out amount detection portion 23, the damage detection portion 24, and the notification portion 28 are electrically connected to the controller 29. The controller 29 may acquire information on the winding wire pull-out amount L detected by the pull-out amount detection portion 23 and the presence or absence of the damage of the winding wire detected by the damage detection portion 24 in real time.

The determinator 34 performs a predetermined determination for detecting the winding wire damage information. The predetermined determination made by the determinator 34 may be one or plural. The winding wire damage information of this embodiment is information indicating that the number of damages included in the winding wire per unit amount (hereinafter simply referred to as "winding wire per unit amount") wound around one split core 7 (winding object) is equal to or more than a predetermined threshold value (e.g. three). That is, in this embodiment, the determinator 34 performs a determination as to whether or not the number of damages included in the winding wire per unit amount is equal to or more than a predetermined threshold value (predetermined determination).

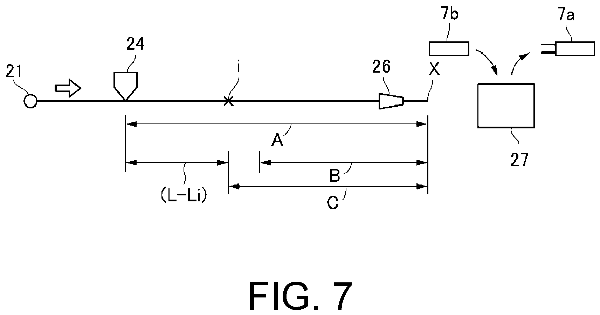

Figure 7 is an explanatory view for detecting damages included in a winding wire per unit amount. Moreover, Figure 7 shows a state in which a damage i of the winding wire has moved to the downstream side of the damage detection portion 24.

The detection of damages included in the winding wire per unit amount by the determinator 34 will be described with reference to Figure 7. Here, a length A of the winding wire from a winding wire cutting position x at which the winding wire is cut after the winding wire is wound around a predetermined split core 7a to the damage detection portion 24, and a length B of the winding wire (winding wire per unit amount) that is to be wound around a next split core 7b and that exists continuously upstream from the winding wire cutting position x are determined to be constant lengths. When the damage detection portion 24 detects the damage i of the winding wire, the determinator 34 stores a winding wire pull-out amount Li at that time in the storage portion each time the damage i is detected. As a result, the determinator 34 may grasp the current position of the damage i (the movement distance from the damage detection portion 24 to the downstream side) from a difference (L-Li) between the current winding wire pull-out amount L and the winding wire pull-out amount Li at the time of damage detection. The determinator 34 calculates the difference (C = A-(L-Li)) between the length A of the winding wire from the winding wire cutting position x to the damage detection portion 24 and a movement distance (L-Li) of the damage i from the damage detection portion 24 to the downstream side for each damage i. At an arbitrary timing before the winding wire is supplied to the next split core 7b (e.g. just before the winding wire to the split core 7b is started), the determinator 34 obtains the number of damages i in which the difference C between the length A of the winding wire and the movement distance (L-Li) of the damage i is shorter than the length B of the winding wire per unit amount (the number of damages I in which (C<B)). That is, the controller 29 detects the number of damages included in the winding wire per unit amount based on the current pull-out amount L detected by the pull-out amount detection portion 23 and the pull-out amount Li when the damage detection portion 24 detects the damage i. Then, the determinator 34 performs a determination as to whether or not the number of damages included in the winding wire per unit amount is equal to or more than a predetermined threshold value (predetermined determination).

The device controller 35 executes a predetermined process when the number of damages included in the winding wire per unit amount is equal to or more than a predetermined threshold value (winding wire damage information is detected) as a result of the predetermined determination made by the determinator 34. In this embodiment, the device controller 35 controls the notification portion 28 to notify the winding wire damage information. Moreover, in this embodiment, the device controller 35 sets the notification portion 28 as the object for executing the predetermined process, and the predetermined process as notification by the notification portion 28, but the object for executing the predetermined process and the predetermined process are not limited thereto. For example, as indicated by a chain double-dashed in Figure 4, the device controller 35 may also control the winding machine 27 as the object for executing the predetermined process when the determinator 34 detects the winding wire damage information. In this case, the device controller 35 may execute a process of stopping the winding machine 27 as the predetermined process, or, after the winding wire is completed, separate the split core 7 wound with the winding wire with the detected winding wire damage information from the normal split core 7 and remove it from the winding machine 27. As a result, distribution of the split cores 7 of low quality (e.g. the split cores 7 wound with the winding wire including many damages) can be prevented.

The winding wire damage information is not limited to information indicating that the number of damages included in the winding wire per unit amount is equal to or more than a predetermined threshold value, as described above, it may be information that there are damages in the winding wire, information that there are damages of a predetermined size or more in the winding wire, or the like. For example, the predetermined determination made by the determinator 34 may be determination as to whether or not the damage detection portion 24 has detected a damage in the winding wire. That is, the device controller 35 may also execute the predetermined process when the damage detection portion 24 detects a damage in the winding wire.

In the winding device 20 configured as described above, the damage detection portion 24 for detecting damages in the winding wire is arranged on the downstream side of the rectangular wire forming machine 22, so damages in the winding wire may be detected in real time during winding wire. As a result, the user may take action according to the detection of damages in the winding wire by the damage detection portion 24, thereby suppressing deterioration in product quality (the split cores 7 distributed in the market) caused by damages in the winding wire.

Further, since the controller 29 for executing a predetermined process based on the damage detection by the damage detection portion 24 is provided, the detection result of a damage in the winding wire may be reflected in the operation of the notification portion 28, the winding machine 27, and the like. Thus, the user may be made aware of the presence of the damage, and the split core 7 of low quality (winding object) may be separated and removed, thereby preventing distribution of the split cores 7 of low quality and suppressing deterioration in product quality due to damages in the winding wire.

Further, the device controller 35 of the controller 29 executes a predetermined process when the number of damages included in the winding wire per unit amount is equal to or more than a predetermined threshold value as a result of the predetermined determination made by the determinator 34. Thus, the user may be made aware of the presence of the split cores 7 of low quality, and the split cores 7 of low quality may be separated and removed, thereby preventing distribution of the split cores 7 of low quality and suppressing deterioration in product quality due to damages in the winding wire.

Further, the pull-out amount detection portion 23 detects the winding wire pull-out amount L, and the controller 29 detects the number of damages included in the winding wire per unit amount based on the present pull-out amount L detected by the pull-out amount detection portion 23 and the pull-out amount Li when the damage detection portion 24 detects a damage i. In this manner, with a simple structure in which the pull-out amount detection portion 23 for detecting the winding wire pull-out amount L is provided, the number of damages included in the winding wire per unit amount may be detected.

Further, the device controller 35 of the controller 29 may execute the predetermined process when the damage detection portion 24 detects a damage in the winding wire. For example, the controller 29 may turn on the lamp (notification portion 28) and immediately turn it off every time the damage detection portion 24 detects a damage in the winding wire.

Moreover, since the notification portion 28 controlled by the controller 29 and capable of notifying the winding wire damage information is provided, the user may be made aware of the winding wire damage information. As a result, the user may take action according to the winding wire damage information, thereby suppressing deterioration in product quality (the split core 7) caused by damages in the winding wire.

Thus, according to this embodiment, damages in the winding wire can be detected in real time during winding wire even in the case where the winding wire is wound around the winding object after the cross-sectional shape thereof is deformed half way, thereby suppressing deterioration in product quality due to damages on the winding wire.

### [Reference Signs List]

7: Split core (winding object)
11: Rectangular wire (winding wire)
13: Round wire (winding wire)
20: Winding device
21: Winding reel (wire supply source)
22: Rectangular wire forming machine (winding wire deformation portion)
23: Pull-out amount detection portion
24: Damage detection portion
27: Winding machine
28: Notification portion
29: Controller (control unit)

## Claims

1. A winding device (20) supplying a winding wire from a wire supply source (21) to a side of a winding object (7) and winding it around the winding object (7), the winding device (20) comprising:
a winding wire deformation portion (22) arranged on a downstream side of the wire supply source (21) and changing a cross-sectional shape of the winding wire; and
a damage detection portion (24) arranged on a downstream side of the winding wire deformation portion (22) and detecting a damage in the winding wire.

2. The winding device (20) according to claim 1, comprising:
a control unit (29) executing a predetermined process based on detection of a damage by the damage detection portion (24).

3. The winding device (20) according to claim 2,
wherein the control unit (29) executes the predetermined process when a number of damages included in a winding wire per unit amount wound around the one winding object (7) is equal to or more than a predetermined threshold.

4. The winding device (20) according to claim 3, comprising:
a pull-out amount detection portion (23) detecting a pull-out amount of the winding wire pulled out from the wire supply source (21),
wherein the control unit (29) detects the number of damages included in the winding wire per unit amount based on a current pull-out amount detected by the pull-out amount detection portion (23) and a pull-out amount when the damage detection portion (24) detects the damage.

5. The winding device (20) according to claim 2,
wherein the control unit (29) executes the predetermined process when the damage detection portion (24) detects the damage in the winding wire.

6. The winding device (20) according to any one of claims 2 to 5, comprising:
a notification portion (28) controlled by the control unit (29) and notifying information about the damage in the winding wire,
wherein the predetermined process executed by the control unit (29) comprises notification by the notification portion (28).
